Europäisches Patentamt

European Patent Office

Office européen des brevets

(11) Veröffentlichungsnummer: **0 460 265 A1**

(12) **EUROPÄISCHE PATENTANMELDUNG**

(21) Anmeldenummer: **90110789.6**

(22) Anmeldetag: **07.06.90**

(51) Int. Cl.5: **G01N 27/04**, G01N 27/12, G01N 27/22

(43) Veröffentlichungstag der Anmeldung:
**11.12.91 Patentblatt 91/50**

(84) Benannte Vertragsstaaten:
**DE GB SE**

(71) Anmelder: **INTEGRATED DISPLAY TECHNOLOGY LTD.**
**41, Man Yue St. Kaiser Estate Block E/E1, 9/F Hung Hom Kowloon(HK)**

(72) Erfinder: **Chan, Raymond**
**Apartment E10, Woodland Heights**
**Wong Nei Chung Gap Road(HK)**

(74) Vertreter: **Lusuardi, Werther Giovanni, Dr.**
**Dr. Lusuardi AG, Kreuzbühlstrasse 8**
**CH-8008 Zürich(CH)**

(54) **Messgerät mit einem Mikroprozessor und einer Beschaltungseinrichtung mit Sensoren.**

(57) Es wird ein Messgerät beschrieben, das einen Mikroprozessor (1) und eine Beschaltungseinrichtung (2) mit mindestens einem Sensor (3) enthält. Durch Änderung der auf den Sensor (3) wirkenden Zustandsgrösse wird ein elektrischer Wert des Sensors (3) geändert und eine Frequenz erzeugt, die im Mikroprozessor (1) ausgekoppelt, über ein sich zyklisch wiederholenden, gleichen Zeitabschnitt ausgezählt und daraus der Wert für die Zustandsgrösse gebildet wird. Die zur Frequenzbildung benötigten Rechteckimpulse werden dem Mikroprozessor (1) entnommen, im Mikroprozessor (1) befinden sich die Prozess-Sensor-Schalter (16) und Prozess-Referenz-Schalter (18), die die Sensoren (3) und Referenzelemente (4) in sich zyklisch wiederholenden, gleichen Zeitabschnitte an die Beschaltungseinrichtung (2) schalten. Das Messgerät hat weniger Bauelemente in seinem Beschaltungsteil, als Messgeräte nach dem Stand der Technik, insbesondere benötigt es dort keine aktiven Halbleiterelemente. Es ist somit billiger und preiswerter. Es kann beispielsweise für Temperaturmessungen, Feuchtemessungen, aber auch zur Messung der auf die Umgebungstemperatur bezogene relative Luftfeuchte verwendet werden.

Fig.2

Die Erfindung betrifft ein Messgerät gemäss dem Oberbegriff von Anspruch 1.

Mit Sensoren werden Zustandsgrössen (beispielsweise eine Luftfeuchte, eine Umgebungstemperatur, ein Sauerstoffgehalt von Abgasen) gemessen, indem durch eine Änderung der Zustandsgrösse eine elektrische Grösse (beispielsweise ein Widerstand, eine Kapazität oder eine Induktivität) des Sensors verändert wird, wodurch sich die Spannung, der Strom oder die Frequenz in einem den Sensor enthaltenden elektrischen Schaltkreis messbar verändert. Solche Sensoren (auch Detektoren oder Messfühler genannt) sind schon lange bekannt.

Neuere Messgeräte für solche Zustandsgrössen enthalten in vielen Fällen einen Mikroprozessor als Auswertmittel, an dem ausgangsseitig eine Anzeigeeinrichtung angeschlossen ist. Um einen Sensor eingangsseitig an einen Mikroprozessor elektrisch anschliessen zu können, benötigte man ursprünglich:
- eine Strom- (oder Spannungs-) Versorgeeinrichtung für den Sensor
- eine Verstärkereinrichtung für den vom Sensor abgegebenen Strom (oder die Spannung) und
- einen Analog-Digitalumsetzer, um das vom Sensor gelieferte Analogsignal in einen dem digital arbeitenden Mikroprozessor verständliches Digitalsignal umwandeln zu können.

Diese dem Mikroprozessor vorgeschalteten Teile, einschliesslich der Sensoren, werden im folgenden als "Beschaltungseinrichtung" bezeichnet.

Eine Messbereichsumschaltung, eine Linearisierung, eine Normierung und eine Berechnung einer von der Zustandsgrösse abhängige Grösse kann dagegen im Mikroprozessor selbst vorgenommen werden. Es entstand so ein erheblicher Aufwand an Schaltmitteln, um einen Sensor an einen Mikroprozessor anzuschliessen.

Weiter waren Beschaltungseinrichtungen bekannt, mit denen die von der Änderung der Zustandsgrösse erzwungene Änderung des Wertes einer elektrischen Grösse eines Sensors direkt zur Änderung der Frequenz eines den Sensor enthaltenden Schaltkreises verwendet wurde. Solche Beschaltungseinrichtungen enthalten einen Oszillator, der mit mindestens einem Sensor für die Zustandsgrösse als Bauelement erster Art und einem Bauelement zweiter Art beschaltet ist. Das Bauelement erster Art kann ein Widerstand, das Bauelement zweiter Art ein Kondensator sein, so dass ein RC-Glied entsteht, das unter Einfluss der Änderung der Zustandsgrösse die Frequenz des Oszillators ändert. Eine solche Schaltung ist beispielsweise in D. Profos, Handbuch der Industriellen Messtechnik, 3. Auflage 1984, S.145, Vulcan-Verlag Essen, für ein Temperaturmessgerät dargestellt. Sie kann eingangsseitig an jeden beliebigen Mikroprozessor in einem Temperaturmessgerät angeschlossen werden.

Als den zur Erfindung nächstliegenden Stand der Technik betrachten wir die EP A1 0 259 012. In ihr werden verschiedene Beschaltungseinrichtungen, die Luftfeuchtesensoren und Temperatursensoren enthalten, an einem Mikroprozessor beschrieben. An den Mikroprozessor wird als Beschaltungseinrichtung ein Oszillator angeschlossen. Dieser besteht aus einem Rechteckschwingungen liefernden Verstärker, der über Halbleiterschalter nacheinander mit einem Referenzwiderstand als Referenzelement, dem Feuchtesensor und/oder dem Temperatursensor, beides Widerstände, also Bauelemente einer ersten Art, verbunden ist. Ein Kondensator mit konstanter Kapazität als Bauelement anderer Art ist dauernd mit dem Verstärker verbunden. Der Oszillator gibt Rechteckimpulse ab, deren Frequenz somit jeweils nacheinander einen Referenzwert, einen Feuchtewert bzw. einem Temperaturwert entspricht. Diese Frequenz wird im Mikroprozessor ausgekoppelt, im beschriebenen Fall daraus die auf die betreffende Umgebungstemperatur korrigierte relative Luftfeuchte berechnet und einer Anzeige zugeleitet. Weiter sind in der genannten Schrift Beschaltungseinrichtungen angegeben, bei denen der Feuchtesensor und der Temperatursensor kapazitiv wirken und das Bauelement einer anderen Art ein Widerstand ist. Die Bauelemente einer ersten Art und die einer anderen Art bilden stets zusammen ein zeitbestimmendes Glied in der Beschaltungseinrichtung.

Die Messgeräte nach dem Stand der Technik benötigen somit eine Beschaltungseinrichtung für den Mikroprozessor, die einen Verstärker und für jeden Sensor wie auch für das Referenzbauelement jeweils einen Halbleiterschalter benötigen.

Es ist Aufgabe der Erfindung, ein Messgerät mit mindestens einem Sensor in einer Beschaltungseinrichtung für einen Mikroprozessor zu schaffen, bei dem die Zahl der in der Beschaltungseinrichtung benötigten Bauelemente noch weiter eingeschränkt ist.

Diese Aufgabe wird durch die im Kennzeichenteil des Anspruchs 1 angeführten Merkmale gelöst, die weiteren Ansprüche enthalten besondere und vorteilhafte Ausführungsformen.

Ausführungsformen der Erfindung werden beispielhaft in der Zeichnung erläutert.

Es zeigen

Fig. 1    eine elektronische Beschaltungseinrichtung zum Anschluss eines Sensors an einen Mikroprozessor gemäss dem Stand der Technik.

Fig. 2    eine elektronische Beschaltungseinrichtung zum Anschluss eines als Widerstand wirkenden Sensors an einen Mikroprozessor entsprechend der Erfindung.

Fig. 3    eine elektronische Beschaltungseinrichtung zum Anschluss eines kapazitiv wirkenden Sensors an einen Mikroprozessor entsprechend der Erfindung.

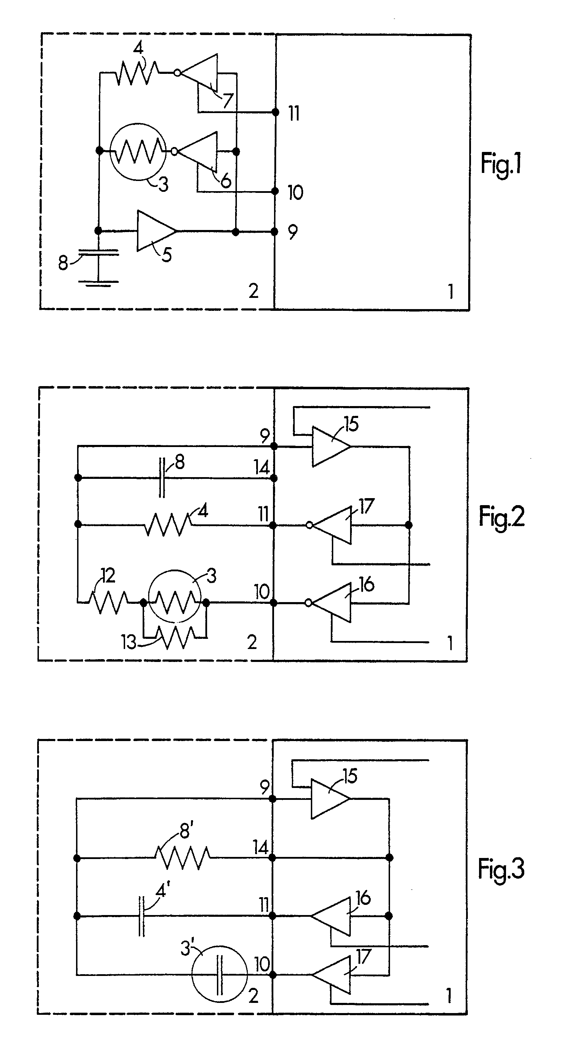

In der Figur 1, die ein Messgerät nach dem in der Schrift EP-A-0 259 012 offenbarten Stand der Technik darstellt, ist mit 1 ein Mikroprozessor und mit 2 eine Beschaltungseinrichtung gezeichnet. Die Beschaltungseinrichtung 2 dient zur Anschaltung eines in der Beschaltungseinrichtung 2 enthaltenen Sensors 3 an den Mikroprozessor 1. Der Sensor 3 ist hier ein als Widerstand wirkender Sensor 3. In der Beschaltungseinrichtung 2 befindet sich ferner ein Referenzwiderstand 4, ein Rechteckimpulse liefernder Verstärker 5, ein Sensorkreis-Schalter 6, ein Referenzkreis-Schalter 7 und ein Kondensator 8. Am Mikroprozessor befindet sich ein Oszillator-Anschluss 9, ein Sensor-Anschluss 10 und ein Referenzkreis-Anschluss 11. In der genannten Schrift sind auch Beschaltungseinrichtungen dargestellt, bei denen der Sensor 3 und das Referenzelement 4 als Kondensator ausgebildet sind und statt des Kondensators 8 ein konstanter Widerstand verwendet ist.

Der Verstärker 5 ist mit dem Mikroprozessor 1 über den Oszillator-Anschluss 9 verbunden. Der Kondensator 8 und - je nach Stellung der Schalter 6 und 7 - der Widerstand des Sensors 3 bzw. der Referenzwiderstand 4 bilden das Zeitglied der Beschaltungseinrichtung 2.

Wird eine Spannung an den Oszillator-Anschluss 9 angelegt, so schwingt die Beschaltungseinrichtung 2 mit einer Frequenz, die vom jeweilig eingeschalteten RC-Glied der Beschaltungseinrichtung abhängt. Diese wird über den Oszillator-Anschluss 9 dem Mikroprozessor 1 zugeführt und dort ausgekoppelt und über vorgegebene Zeitabschnitte ausgezählt (beides nicht gezeichnet).

Ist der Sensor-Anschluss 10 "hoch" gesetzt, so schliesst der Sensorkreis-Schalter 6 und der Sensor 3 ist als frequenzbestimmender Widerstand in die Beschaltungseinrichtung 2 eingeschaltet. Deren Frequenz ist durch den Wert der auf den Sensor 3 wirkenden Zustandsgrösse bestimmt. Ist der Referenzkreis-Anschluss 10 "hoch" gesetzt, so schliesst der Referenzkreis-Schalter 7 und der konstante Referenzwiderstand 4 ist als frequenzbestimmender Widerstand in die Beschaltungseinrichtung 2 eingeschaltet, seine Frequenz bleibt dann auf einem konstanten Referenzwert. Der Mikroprozessor 1 enthält eine Einrichtung (nicht gezeichnet), die über eine vorgegebene Zeit jeweils abwechseln den Sensor-Anschluss 10 "hoch" setzt und es ermöglicht, die mit dem Sensor 3 erzeugte Frequenz auszuzählen bzw. den Referenz-Anschluss 23 "hoch" setzt und es ermöglicht, die vom Referenzwiderstand 4 erzeugte konstante Referenzfrequenz auszuzählen.

Das Messgerät nach Figur 1 enthält somit in seiner Beschaltungseinrichtung 2 noch aktive Halbleiterbauelemente, nämlich:
- den Verstärker 5
- den Sensorkreis-Schalter 6
- den Referenzkreis-Schalter 7

Die Figur 2 stellt beispielhaft ein erfindungsgemässes Messgerät dar, bestehend aus einem Mikroprozessor 1 und einer Beschaltungseinrichtung 2. Mit der Beschaltungseinrichtung 2 wird auch hier ein Sensor 3 an den Mikroprozessor 1 angeschlossen. In der Beschaltungseinrichtung 2 befinden sich ferner ein Referenzwiderstand 4 und ein Kondensator 8. Zur Anpassung des Sensors 3 wird weiter bei dem Messgerät nach der Figur 2 ein Serienwiderstand 12 und ein Parallelwiderstand 13 zur Anpassung des Sensors 3 an die anderen Werte der Beschaltungseinrichtung 2 vorgesehen, die in der Figur 1 nicht gezeichnet sind.

Vom Mikroprozessor 1 werden folgende Bauteile zur Funktion der Schaltung beigezogen:
Ein Oszillator-Anschluss 9, ein Sensor-Anschluss 10 und ein Referenzkreis-Anschluss 11, ferner ein Kondensator-Anschluss 14, ein Oszillator-Schalter 15, ein Prozessor-Sensor-Schalter 16 und ein Prozessor-Referenz-Schalter 17.

Über den Oszillator-Schalter 15 und den Oszillator-Anschluss gibt der Mikroprozessor 1 Rechteckimpulse an die Beschaltungseinrichtung 2 ab, deren Frequenz von dem RC-Glied in der Beschaltungseinrichtung 2 abhängt.

Diese wird durch die Kapazität des Kondensators 8 und - bei geschlossenem Prozessor-Sensor-Schalter 16 - durch den Widerstand des Sensors 3 oder - bei geschlossenem Prozessor-Referenz-Schalter 17 - durch den Referenzwiderstand 4 bestimmt. Die Widerstände 3,4 und Kondensatoren 8 können auch in anderer Weise zu einem zeitbestimmenden Glied angeordnet sein. Die Frequenz ist durch den vom Wert der Zustandsgrösse abhängigen Widerstand des Sensors 3 bestimmt, wenn der Prozessor-Sensor-Schalter 16 geöffnet ist. Die Frequenz wird vom Referenzwiderstand 4 auf einem konstanten Referenzwert gehalten, wenn der Prozessor-Referenz-Schalter 17 geschlossen ist. Dass diese Stellungen in sich zyklisch wiederholenden gleichen Zeitabschnitten eingenommen werden, wird über die Software zum Mikroprozessor 1 veranlasst. Im Mikroprozessor 1 wird die Frequenz ausgekoppelt und über dieselben Zeitabschnitte wie oben ausgezählt und daraus die Zustandsgrösse berechnet (zu diesen drei Vorgängen ist in der Figur 2 nichts gezeichnet).

Das in der Figur 2 dargestellte Messgerät ist eine spezielle Ausführungsform eines erfindungsgemässen Messgerätes mit allgemeinen Eigenschaften, das im Folgenden beschrieben wird:

Es besteht aus einem Mikroprozessor 1 als Auswertmittel und einer Beschaltungseinrichtung 2 und mindestens einem Sensor 3. Die Beschaltungseinrichtung 2 enthält Bauelemente einer ersten Art, nämlich Sensoren 3 und Referenzelemente 4 und Bauelemente einer anderen Art 8. Jeweils ein Paar von Bauelemente 3,4,8 besteht aus einem Bauelement der ersten Art 3,4 und einem Bauelement einer anderen Art 8. Ein solches Paar ist zu einem zeitbestimmenden Glied 3 und 8, sowie 4 und 8 zusammengeschlossen und wird über einen sich im Mikroprozessor 1 befindlichen Prozessor-Sensor-Schalter 16 bzw. Prozessor-Referenzschalter 17 während sich zyklisch wiederholenden, gleichen Zeitabschnitten verbunden. Im Mikroprozessor 1 werden ferner Rechteckimpulse erzeugt, die über den im Mikroprozessor 1 befindlichen Oszillatorschalter 17 an die Beschaltungseinrichtung 2 übertragen werden, wo ihre Frequenzen durch die zeitbestimmenden Glieder 3 und 8, sowie 4 und 8 bestimmt werden. Die Prozess-Sensor-Schalter 16 bzw. die Prozess-Referenz-Schalter 17 im Mikroprozessor 1 sind durch die Software des Mikroprozessors so gesteuert, dass jeweils nur ein Paar von Bauelementen 3 und 8, sowie 4 und 8 in der Beschaltungseinrichtung 2 zur Bildung der Frequenzen wirksam sind. Diese Frequenzen werden wieder dem Mikroprozessor 1 zugeführt, wobei sie in den sich zyklisch wiederholenden, gleichen Zeitabschnitten ausgezählt werden und aus den ausgezählten Werten die Werte der Zustandsgrösse berechenbar sind.

Für das erfindungsgemässe Messgerät muss somit ein Mikroprozessor 1 ausgewählt werden, so dass eine Impulsfolge entsteht, deren Frequenz davon abhängt, welcher der zeitbestimmenden Glieder 3 und 8; 4 und 8 an den Mikroprozessor 1 angeschlossen ist. Das Anschliessen eines dieser zeitbestimmenden Glieder 3 und 8, 4 und 8 während der zyklisch sich wiederholenden, gleichen Zeitabschnitten wird durch sich im Mikroprozessor 1 befindliche Bauelemente, hier Prozessor-Sensor-Schalter 16 und Prozessor-Referenzschalter 17 genannt, vermittelt. Mikroprozessoren mit diesen Eigenschaften sind bekannt.

Die Beschaltungseinrichtung 2 enthält somit im Gegensatz zu den Messgeräten nach dem Stand der Technik keinerlei aktive Halbleiterelemente, d.h. lediglich passive Bauelemente.

Um Polarisationen am Sensor 3 zu vermeiden, sollten die Rechtecksignale vorzugsweise symmetrisch zur Nullspannung liegen.

Als Sensoren 3 können Feuchtesensoren, Temperatursensoren oder Sensoren für andere Zustandsgrössen verwendet werden.

Als Paare von Bauelementen der ersten Art und der anderen Art können folgende Kombinationen auftreten

| Bauelement der ersten Art | Bauelement der anderen Art |
| --- | --- |
| Widerstand | Kondensator |
| Widerstand | Induktivität |
| Kondensator | Widerstand |
| Induktivität | Widerstand |

In der Figur 3 ist ein Messgerät gezeichnet, bei dem als Bauelemente der ersten Art ein Sensor 3' und ein Referenzelement 4', beide als Kondensatoren und als Bauelement der anderen Art ein Widerstand 8' verwendet sind. Statt der Kondensatoren 3',4' könnten auch Induktivitäten verwendet werden.

Weiter ist es möglich, auch als Bauelement der anderen Art einen Sensor zu benutzen, der den Einfluss einer zweiten Zustandsgrösse auf die erste Zustandsgrösse beeinflusst, die auf einen Sensor 3 wirkt, der von der ersten Art ist. Dieser Sensor muss sorgfältig an die Werte der Beschaltungseinrichtung angepasst werden. Als Beispiel sei ein Temperatursensor erwähnt, der einen Feuchtesensor beeinflusst.

Durch die Erfindung ist es gelungen, ein Messgerät mit einer Beschaltungseinrichtung 2 mit mindestens einem Sensor 3 und einem Mikroprozessor zu schaffen, bei dem die Zahl der in der Beschaltungseinrichtung 2 benötigten Bauelemente gegenüber dem Stand der Technik verringert ist, bei der insbesondere die Beschaltungseinrichtung 2 keine aktiven Halbleiterbauelemente mehr, d.h. lediglich passive Bauelemente, aufweist. Diese Ausführungsform ist preiswerter und weniger störanfällig als die nach dem Stand der Technik. Das Gerät kann beispielsweise zu Temperaturmessungen, zu Feuchtemessungen, aber auch zur Messung der auf die Umgebungstemperatur bezogenen relativen Luftfeuchte (Hygrometer) verwendet werden.

**Patentansprüche**

1.  Messgerät mit einem Mikroprozessor (1) und einer Beschaltungseinrichtung (2) mit mindestens einem

EP 0 460 265 A1

Sensor (3), mit dem Werte von den die Sensoren (3) beeinflussenden Zustandsgrössen bestimmbar sind, dadurch gekennzeichnet, dass A) im Mikroprozessor (1) eine Impulsfolge bildbar ist, die durch äussere Beschaltung in beliebigen Frequenzen erzeugbar ist, B) die Beschaltungseinrichtung (2) als Bauelemente einer ersten Art die Sensoren (3) und Referenzelemente (4) und Bauelemente einer anderen Art (8) enthält, wobei jeweils ein Paar von Bauelementen (3,4,8) bestehend aus einem Bauelement der ersten Art (3,4) und einem Bauelement einer anderen Art (8) zu einem zeitbestimmenden Glied zusammengeschlossen und mit dem Mikroprozessor (1) über sich zyklisch wiederholenden, gleichen Zeitabschnitten verbunden sind und bei dem sich durch die zeitbestimmenden Glieder (3 und 8; 4 und 8) Frequenzen ergeben, die dem Mikroprozessor (1) zugeführt, in den sich zyklisch wiederholenden, gleichen Zeitabschnitten auszählbar sind und aus den ausgezählten Werten die Werte für Zustandsgrössen bildbar sind.

2. Messgerät nach Anspruch 1, dadurch gekennzeichnet, dass die Beschaltungseinrichtung (2) keinerlei aktive Halbleiterbauelemente aufweist.

3. Messgerät nach Anspruch 1 oder 2, dadurch gekennzeichnet, dass die Beschaltungseinrichtung (2) lediglich passive Bauelemente (3,4;8,12,13) enthält.

4. Messgerät nach einem der Ansprüche 1 bis 3, dadurch gekennzeichnet, dass im Mikroprozessor (1) Rechteckimpulse erzeugbar sind, diese von einem im Mikroprozessor befindlichen Oszillatorschalter (15) auf die Beschaltungseinrichtung (2) übertragbar sind und die im Mikroprozessor (1) befindlichen Prozessor-Sensor-Schalter 16 bzw. Prozessor-Referenz-Schalter 17 so gesteuert sind, dass jeweils nur ein Paar von Bauelementen (3 und 8; 4 und 8) in der Beschaltungseinrichtung (2) zur Bildung der Frequenzen wirksam sind.

5. Messgerät nach einem der Ansprüche 1 bis 4, dadurch gekennzeichnet, dass die Rechtecksignale symmetrisch zur Nullspannung liegen.

6. Messgerät nach einem der Ansprüche 1 bis 5, dadurch gekennzeichnet, dass ein Sensor (3) ein Feuchtesensor ist.

7. Messgerät nach einem der Ansprüche 1 bis 6, dadurch gekennzeichnet, dass ein Sensor (3) ein Temperatursensor ist.

8. Messgerät nach einem der Ansprüche 1 bis 7, dadurch gekennzeichnet, dass als Paare von Bauelementen (3,4,8) folgende Kombinationen auftreten können

| Bauelement der ersten Art | Bauelement der anderen Art |
| --- | --- |
| Widerstand | Kondensator |
| Widerstand | Induktivität |
| Kondensator | Widerstand |
| Induktivität | Widerstand |

9. Messgerät nach einem der Ansprüche 1 bis 8, dadurch gekennzeichnet, dass das Bauelement anderer Art ebenfalls ein Sensor (3) ist, der so an die Werte der Beschaltungseinrichtung (2) angepasst ist, dass er den Einfluss einer zweiten Zustandsgrösse auf eine Zustandsgrösse, die auf einen Sensor (3), der von der ersten Art ist, kompensiert.

10. Hygrometer mit einem Messgerät nach einem der Ansprüche 1 bis 9.

5

Fig.1

Fig.2

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-0 259 012 (NIPPON MINING CO. LTD.) <br> * Zusammenfassung * * Seite 5, Zeilen 11 - 42; Figur 1 * * Seite 9, Zeile 29 - Seite 10, Zeile 44; Figuren 11, 12 * * Seite 11, Zeilen 1 - 28; Figur 16 * <br> – – – | 1-10 | G 01 N 27/04 <br> G 01 N 27/12 <br> G 01 N 27/22 |
| Y | DE-A-2 121 959 (AUERGESELLSCHAFT GMBH) <br> * Seite 1, Zeile 1 - Seite 2, Zeile 10; Figur 1 * * Seite 4, Zeile 27 - Seite 5, Zeile 27; Figuren 4-6 * <br> – – – | 1-10 | |
| A | SENSOR AND ACTUATORS. vol. 12, no. 2, August 1987, LAUSANNE CH Seiten 145 - 157; KURT V. HEBER: "Humidity measurement at high temperatures" <br> * Seite 155, Zeile 10 - Seite 156, Zeile 8; Figuren 9, 10 * <br> – – – | 1-10 | |
| A | US-A-4 849 687 (JACKIE C. SIMS) <br> * Zusammenfassung * * Spalte 2, Zeilen 30 - 59; Figur 1 * <br> – – – | 1 | |
| A | WO-A-8 807 678 (EFTAG ENTSTAUBUNGS- UND FÖR-DERTECHNIK AG) <br> * Zusammenfassung * * Seite 6, Zeile 9 - Seite 7, Zeile 2; Figur 3 * <br> – – – – – | 1 | |

|  | RECHERCHIERTE SACHGEBIETE (Int. Cl.5) |
|---|---|
|  | G 01 N |

Der vorliegende Recherchenbericht wurde für alle Patentansprüche erstellt

| Recherchenort | Abschlußdatum der Recherche | Prüfer |
|---|---|---|
| Berlin | 10 Januar 91 | MOUTARD P.J. |